# EUROPEAN PATENT SPECIFICATION

(11) **EP 0 665 983 B1**
(45) Date of publication and mention of the grant of the patent: **09.09.1998**
(21) Application number: 93913362.5
(22) Date of filing: 14.06.1993
(51) Int. Cl.: H01L 31/18, H01L 31/04, G01T 1/24, G21H 1/06

(54) **A METHOD OF PRODUCING DEVICES WHICH GENERATE ELECTRICAL ENERGY**
VERFAHREN ZUR HERSTELLUNG VON ELEKTRISCHE ENERGIE ERZEUGENDEN VORRICHTUNGEN
PROCEDE DE PRODUCTION DE DISPOSITIFS GENERANT DE L'ENERGIE ELECTRIQUE

(30) Priority: 13.06.1992 GB 9212585
(43) Date of publication of application: 09.08.1995
(73) Proprietor: Boardman, Jeffery, Warrington, Cheshire WA4 5DA (GB)
(72) Inventor: Boardman, Jeffery, Warrington, Cheshire WA4 5DA (GB)
(74) Representative: Atkinson, Peter Birch
(86) International application number: GB9301261
(87) International publication number: WO9326052

(56) References cited:
- EP-A- 0 526 817
- DD-A- 132 616
- US-A- 4 276 441
- PATENT ABSTRACTS OF JAPAN, unexamined application, E section, vol. 13, no. 232, May 29, 1989 THE PATENT OFFICE JAPANESE GOVERNMENT page 162 E 765, N

## Description

The present invention relates to a method of constructing photo voltaic diodes, particularly but not exclusively to radiation hard solid state diodes constructed from laminations of n and p type metals or metallic oxides such that electron hole pairs are formed in the depletion layer under the influence of incident radiation.

Devices for converting radiation directly into electrical energy can be classified roughly into three types:-
(a) Equipment having a metal collector set in a vacuum tube which collect the electrons given off by a radiating source and which generate a potential between the source and the collector.
   Such devices are well known and over a suitable period of time will generate high potential voltages between the emitting source and the collector.
(b) Gas ionisation electric cells, whereby radiation causes ionisation in a gaseous medium, generating ion electron pairs which are subsequently directed to electrodes by an electric field generated by the device itself, thus producing an electric current which can be harnessed for use.
(c) Solid state ionisation devices, along the lines of photo voltaic cells, where the nuclear radiation replaces light photons as the generating source.

The present invention is concerned with this latter type of energy producing device.

Current solid state devices based on silicon are not radiation hard and have a very limited life in environments where intense levels of radiation energy is present.

It is an object of the present invention to provide an alternative means of forming solid state photovoltaic diodes which are radiation hard and will generate electrical energy from exposure to nuclear radiation over prolonged periods of several years.

According to the present invention there is provided a method of constructing a photovoltaic diode capable of generating electrical energy from exposure to nuclear radiation the method comprising the steps of:
(a) preparing dry metal powders of transition metals having non symmetrically shaped particles having sizes in the range of 1 to 45 micrometers;
(b) preparing the surface of a supporting substrate such that the surface is substantially chemically clean and electrically conductive;
(c) cooling the surface of the supporting substrate to a temperature within the range -200 to -20°C ; and
(d) heating the dry metal powders to a temperature at which the particles thereof become partially molten, thus at least partially oxidising the metal, depositing the molten oxide onto said surface of the supporting substrate to form at least one layer of an oxide matrix having n or p type characteristics and depositing an electrically conducting layer onto the oxide matrix layer.

The basis of the new process is to utilise a hot spraying technique to deposit a series of layers of different metals or metallic oxides so as to produce n and p type junctions.

The hot spraying technique consists of passing a stream of very finely powdered metal particles through a heat source, during which process the particles become molten and are chemically changed to the relevant oxide and which when projected onto an appropriate substrate form a homogeneous oxide matrix layer.

The heating sources may take the form of a plasma device, or an arc struck between two wires, such that the wires melt and the molten droplets are projected as a stream onto a surface, or a flame source formed from the reaction of oxygen with hydrocarbon gases or liquids.

The most cost effective devices are of the flame spray type utilising combustion gases, such as hydrogen, propane or acetylene.

A suitable method of producing the dry metal powders is to blast a molten mixture of the metal into water and no subsequently crush and dry the resulting water atomised powders.

The degree to which the sprayed metal oxide matrices demonstrate their n or p type properties depends upon the degree to which the metal particles are chemically converted to an oxide whilst passing through the heat source.

This reaction is time, temperature dependent and also requires the presence of free oxygen in the heat source.

For the flame spray process it has been determined that the ratio of oxygen to the combustion gases, in volumetric terms, must be twice that required for stoichiometric combustion conditions.

In addition, for the reaction to proceed satisfactorily during the short time it takes the metal particles to pass through the heating source, the particles must reach a temperature at which they become fully molten and remain so to the point where they impact onto the substrate surface.

Conventional metal flame spraying equipment is not fully suitable in meeting the required conditions and will only do so when modified.

In conventional equipment the combustion flame is unrestrained and loses a great deal of its heat to the surrounding air and in addition the powder stream passing through the combustion flame forms a divergent cone, whereby the outer streams of metallic particles reach a lower temperature than those in the centre.

The optimum conditions for the production of oxidised particles from a metal powder is to utilise a narrow combustion flame, so constrained as to minimise the heat loss to the surrounding air, and to propagate as narrow a stream of particles through it, as possible.

These conditions are achieved by using a heat resistant tube, having an internal diameter of twice the flame diameter and a length of 50% to 70% of the flame length, positioned coaxially around the flame such that the stream of molten particles do not impinge onto the tube inner surface.

The location of the tube around the combustion flame and particle stream is critical and can be adjusted by using a suitable mechanical device fixed to the combustion nozzle.

The effect of this tube on the combustion system is two fold, firstly it promotes laminar gas flow conditions within the flame and molten particle stream and secondly it greatly reduces heat losses to the surrounding environment promoting a much more even temperature within the particle stream.

The promotion of laminar flow and constriction of the dispersion of the molten particle stream is also enhanced by the provision of a ring of small inclined nozzles, situated above the top edge of the heat resistant tube and impinging onto the flame and particle stream. These nozzles may be used to deliver a separate gas than that used in the combustion process, either inert or reactive as required.

The temperature at which metals become molten varies with the individual metal and therefore there must be a balance between the rate at which each type of metal powder is processed and the total heat from the combustion source. For the flame spraying process this is achieved by varying the volumetric flow of the combustion gases, whilst maintaining the correct volumetric ratios.

The first step in the process is to chemically prepare the substrate such that it presents a clean surface to the molten particles.

The substrate may be either a metal, ceramic; glass, tiles, bricks, etc, or a composite, glass fibre laminates, mica, plastic, or concrete, as the flexibility of the process is such that the oxide matrices may be made to adhere satisfactorily to a wide range of materials, either of a flat or shaped profile.

The second step in the precess is to accurately align the substrate to the heating source at such a distance that the oxide particles are still molten at the point of impact with it. This may be done in either vertical or horizontal planes. This spray distance has been found to be dependent upon several factors which include, the type of substrate to be coated, combustion flame and molten particle temperatures, required deposit thickness and rate of particle deposition.

Empirical trials have shown that this varies from 5 mm to 40 mm from the extreme edge of the heat resistant tube support.

The third step in the process is to pass the stream of molten metal oxide particles rapidly over the substrate in a plurality of overlapping passes to form a homogeneous matrix layer of interlocking oxide particles of either an n type or p type oxide.

The thickness of the oxide matrix may be predetermined by varying the process parameters, such as, rate of feed of the metal powder into the combustion flame and the speed and plurality of the passes of the molten oxide particle stream over the substrate.

One factor which has a great influence on both the rate of oxidation of the particles and the homogeneity of the deposited matrix is the form of the original metal powder particles and their size range.

For a rapid rate of oxidation it is necessary that the ratio of particle surface area to volume is as high as possible and that the total surface area per unit volume of the powder is similarly high.

Spherically shaped metal powder particles, as are produced by gas atomisation, have been found to be unsuitable.

The success of the process depends to a large extent on the original metal particles having a non symmetrical shape, with reentrant profiles, such as are produced by the water atomisation process and being widely dispersed in size over the range of 45 micrometers to +1 micrometer. The large particle surface area enhances oxide formation and the non symmetrical shape promotes interlocking with both the substrate and other particles, ensuring good interparticulate adhesion of the oxidised surfaces.

As previously mentioned, the degree to which the sprayed oxide matrices demonstrate their n or p type properties is dependent upon the degree of oxidation of the molten metal particles. The more oxidised the matrix, the greater is the degree of n or p type property. This property may be varied as required by adjusting the various process parameters, i.e. temperature, total flameheat, particle through put and size range, ratio of oxygen to combustion gases, and spray distance.

The deposited oxide matrices are polycrystalline in nature and are capable of analysis, by conventional methods, including 'X' ray diffraction.

Where the matrices are less than fully oxidised, examination by optical techniques shows them to contain a random dispersion of metal particles distributed within the oxide.

The capability of the process to produce a cohesive, homogeneous matrix with a proportion of randomly dispersed metallic particles is of great importance, as is the capability to vary the proposition of metallic particles to matrix oxide and will be explained later.

The metals and their oxides used in this process to produce photo voltaic diodes are those situated in the transition region of the periodic table of elements, and are commonly known as the transition metals.

The oxide matrices of such transition metals in the as sprayed polycrystalline state have either a p or n type characteristic and therefore a lamination of the appropriate oxides; one p type, the second n type, of any two metals within the transition metal series may be used to produce a photo voltaic diode, by this process.

For example a polycrystalline as sprayed oxide matrix of nickel demonstrates the n type property, whereas the polycrystalline oxide matrices of iron, cobalt, or copper, demonstrate a p type property. Thus a combination of the oxides of nickel and iron, nickel and cobalt, or nickel and copper can be used.

Furthermore, it is known that the susceptibility of these oxides to generate charge carriers is enhanced by the addition of small amounts of the alkali metals and alkaline earth metals [Group IA and IIA] and other elements from the lanthanide and actinide periods of the periodic table.

For example, nickel oxide mixed with a small proportion of lithium oxide will have a more stable behaviour.

Thus the process may be used not only to produce oxide matrices from the transition metals, but also oxide matrices, made of the transition metals and additions of the alkali metals and alkaline earth metals and other elements from the lanthanide and actinide periods of the periodic table, to manufacture photo voltaic diodes. The basic format of a photo voltaic diode produced by the above process consists of a metal substrate onto which is deposited a thin oxide matrix of one metal to give a p or n type layer. Onto this is deposited a second oxide matrix to give the alternate type layer, which is in turn covered by a metallic layer.

A depletion zone is formed at the junction of the n and p type matrices with consequent development of a potential across it.

The metal substrate has two functions in that it provides the necessary strength to support the two laminated oxides, but also acts as a charge collector to which a contact may easily be made. The outer metallic layer also acts as a charge collector.

A typical diode will consist of a plate of mild steel onto which is first deposited an iron oxide matrix, p type, over which is laid a nickel oxide matrix, n type, and which is in turn coated with an electro-deposited layer of pure nickel.

The points of contact of the iron and nickel oxides forms the depletion layer, the mild steel substrate and electro-deposited nickel form the collectors and contacts.

Exposure of the diode to radiation, principally of the Beta and Gamma forms results in the generation of electron hole pairs in the depletion layer which migrate to the appropriate collectors to generate an external current.

The thickness of the depletion layer has a considerable effect on the efficiency and operation of the diode, in that the thinner it is, the greater is the voltage field across it.

However, the collection of incoming radiation and generation of electron hole pairs is improved by increasing the volume/thickness of the depletion layer.

The presence of increasing amounts of metallic inclusions will assist the passage of the charge carriers to the collectors. the metallic inclusions may also assist in producing an electron cascade effect.

The diodes capable of being manufactured by this process are intended to generate electron-hole pairs not only from direct penetration by radiation particles, but also from the cascade effect; whereby the primary radiation is made to penetrate an initial substrate, such as the metal charge collectors, or even the dispersed metal particles within the oxide matrices and generate a cascade of secondary electrons, which in turn enter the depletion zone creating further electron-hole pairs and thereby increasing the efficiency of the diode.

Examples of typical configurations of the diodes and emitting sources can be as follows;
(a) As planar laminates, whereby successive central substrates coated on both sides with an oxide matrix laminate of n and p type materials, covered in turn by an outer metal collector layer, are interspersed by thin plates of radioactive material. The electrical connections being taken successively from the central substrates and outer metal collector layers.
   In this configuration each diode is irradiated from both sides and such an arrangement would be used in the fields of measurement, instrumentation and control, or as reserve power supplies in remote or hostile environments such as nuclear plants or in space.
(b) As a tubular arrangement whereby a metal tube is coated internally and externally with firstly a laminate of n and p type oxide matrices and then a metal collector layer and arranged coaxially around a rod of radioactive material. With such a configuration the electrical connections would be made to the tube and the metal collector layers.
(c) In a spherical configuration a metal sphere, coated internally and externally with a laminate of n and p type oxide matrices and then a metal collector layer, with the radioactive source placed at the centre, irradiating uniformly onto the inside surface.
   The electrical connections being made to the metal sphere and metal collector layers, with suitable insulation where they passed through the shell and oxide layers.

The potential uses for such photovoltaic diode devices are extremely wide and range from power sources for electronic devices, to detectors of various forms and intensities of nuclear and other types of radiation in the fields of measurement instrumentation and control.

## Claims

1. A method of constructing a photovoltaic diode capable of generating electrical energy from exposure to nuclear radiation the method comprising the steps of:
(a) preparing dry metal powders of transition metals having non symmetrically shaped particles having sizes in the range of 1 to 45 micrometers;
(b) preparing the surface of a supporting substrate such that the surface is substantially chemically clean and electrically conductive;
(c) cooling the surface of the supporting substrate to a temperature within the range -200 to -20° C; and
(d) heating the dry metal powders to a temperature at which the particles thereof become partially molten. thus at least partially oxidising the metal. depositing the molten oxide onto said surface of the supporting substrate to form at least one layer of an oxide matrix having n or p type characteristics and depositing an electrically conducting layer onto the oxide matrix layer.

2. A method as claimed in claim 1, wherein the metal powders have re-entrant angles.

3. A method as claimed in any preceding claim, wherein the surface of the supporting substrate is cooled to a temperature within the range -200 to -100°C.

4. A method as claimed in any preceding claim, wherein the metal powders are partially melted by a plasma, an are between two metal wires, a wire and an electrode, or flame spraying equipment.

5. A method as claimed in any preceding claim, wherein at least one a type and one p type oxide matrix is deposited onto the surface of the supporting substrate.

6. A method as claimed in claim 5, wherein the molten oxides are deposited onto the substrate to form a laminate of oxide matrices having alternate layers of n type and p type characteristics.

7. A method as claimed in any preceding claim, wherein the molten oxides are deposited onto the surface of the supporting substrate in a plurality of passes over the substrate.

8. A method as claimed in any preceding claim, wherein the electrically conducting layer is deposited onto the oxide laminate by electrodeposition, in fluid or vacuum, or by mechanical means.

9. A method as claimed in any preceding claim, wherein the dry metal powders are formed by blasting a molten mixture of the metal into water and subsequently crushing and drying the resulting water atomised powders.

10. A method as claimed in any preceding claim, wherein the metal powders comprise any of those elements classified as transition metals in the periodic table of the elements, having atomic numbers ranging from 21 to 30, 39 to 48, 57 to 80 and 89 to 107 inclusively, either in their pure state or alloyed in varying proportions with one or more of the elements in other groups of the periodic table of the elements, having the atomic number 3, 4, 11, 12, 13, 14, 15, 16, 19, 20, 31 to 34 inclusive, 37, 38, 49 to 52 inclusively, 55, 56, 81 to 88 inclusively, and 58 to 71 (lanthanides) and 90 to 103 (actinides) inclusively.

11. A method as claimed in any preceding claim, wherein the degree to which the oxide matrices demonstrate their **n** and **p** type properties is governed by adjusting the amount of oxidation on the surfaces of the metallic particles of the powders, either by adjusting the process parameters, or varying the location of a heat resistant tube with respect to the heat source and the molten particle stream, or by selecting the size range of the particles used, within the range of 1 to 45 micrometers.

12. A method as claimed in any preceding claim, wherein the ability of the transition metal powders comprising elements having atomic numbers ranging from 21 to 30 inclusively, 39 to 48 inclusively, 57 to 80 inclusively and 89 to 107 inclusively to generate charge carriers from the incidence of radiation is enhanced by the addition to them in varying proportions of one or more of the elements in the periodic table of elements having the atomic numbers 3, 4, 11, 12, 13, 14, 15, 16, 19, 20, 31 to 34 inclusively, 37, 38, 49 to 52 inclusively, 55, 56, 81 to 88 inclusively, 58 to 71 inclusively and 90 to 103 inclusively.

13. A method as claimed in any preceding claim, wherein the thickness of the sprayed oxide matrices, whether of **n** or **p** type, and their conductivities are adjusted by varying the degree of oxidation on the surface of the molten metal particles and the plurality and speed of passes over the supporting substrate.

14. A method as claimed in any preceding claim, wherein when the oxide matrices are produced by flame spraying, the volumetric ratio of oxygen to the associated fuel in the combustion flame, is twice that required for stoichiometric combustion.

15. A method as claimed in any preceding claim, wherein the deposition of a laminate of two oxide matrices, one being **n** type and the other being **p** type, onto a suitably prepared supporting substrate and subsequent deposition onto the oxide laminate of a suitable collecting surface will produce a photovoltaic diode capable of generating electrical energy directly from the incidence of nuclear radiation.

16. A method as claimed in any preceding claim, wherein the laminate of two oxide matrices, **n** and **p** type, and suitable collecting surface are applied to both surfaces of a suitably prepared supporting substrate, either in flat, tubular or spherical form, or any combinations of these forms, to produce photovoltaic diode combinations which will directly generate electrical energy from nuclear radiation incident onto the relevant surface from a variety of radioactive sources.

## Patentansprüche

1. Verfahren zum Bauen einer Sperrschichtphotodiode, die in der Lage ist, durch Aussetzen an Kern strahlung elektrische Energie zu erzeugen, wobei das Verfahren folgende Schritte umfaßt:
(a) Herstellung von Trockenmetallpulvern aus Übergangsmetallen mit Teilchen unsymmetrischer Form von Größen im Bereich zwischen 1 und 45 Mikrometern;
(b) Vorbereiten der Oberfläche eines tragenden Substrats derart, daß die Oberfläche im wesentlichen chemisch rein und elektrisch leitfähig ist;
(c) Kühlen der Oberfläche des tragenden Substrats auf eine Temperatur innerhalb des Bereichs von -200 bis -20 °C; und
(d) Heizen der Trockenmetallpulver auf eine Temperatur, bei der die Teilchen derselben teilweise schmelzen und das Metall dabei zumindest teilweise oxidiert wird, Aufbringen des geschmolzenen Oxids auf die Oberfläche des tragenden Substrats zur Bildung mindestens einer Schicht einer Oxidmatrix mit einer Charakteristik vom n- oder p-Typ und Aufbringen einer elektrisch leitfähigen Schicht auf die Oxidmatrixschicht.

2. Verfahren nach Anspruch 1, bei dem die Metallpulver einspringende Winkel aufweisen.

3. Verfahren nach einem der vorhergehenden Ansprüche, bei dem die Oberfläche des tragenden Substrats auf eine Temperatur innerhalb des Bereichs von -200 bis -100 °C gekühlt wird.

4. Verfahren nach einem der vorhergehenden Ansprüche, bei dem die Metallpulver teilweise durch ein Plasma, einen Lichtbogen zwischen zwei Metalldrähten, einem Draht und einer Elektrode, oder Flammenspritzgeräte geschmolzen werden.

5. Verfahren nach einem der vorhergehenden Ansprüche, bei dem zumindest eine Oxidmatrix vom n-Typ und eine vom p-Typ auf die Oberfläche des tragenden Substrats aufgebracht wird.

6. Verfahren nach Anspruch 5, bei dem die geschmolzenen Oxide auf das Substrat zur Bildung eines Laminats von Oxidmatrizen mit abwechselnden Schichten einer Charakteristik vom n-Typ oder p-Typ aufgebracht werden.

7. Verfahren nach einem der vorhergehenden Ansprüche, bei dem die geschmolzenen Oxide auf die Oberfläche des tragenden Substrats durch mehrmaliges Überleiten über das Substrat aufgebracht werden.

8. Verfahren nach einem der vorhergehenden Ansprüche, bei dem die elektrisch leitfähige Schicht durch elektrochemisches Abscheiden in einem Fluid oder Vakuum oder auf mechanischem Wege auf das Oxidlaminat aufgebracht wird.

9. Verfahren nach einem der vorhergehenden Ansprüche, bei dem die Trockenmetallpulver durch Einblasen einer geschmolzenen Metallmischung in Wasser und darauffolgendes Zerkleinern und Trocknen der dadurch gebildeten in Wasser zerstäubten Pulver gebildet werden.

10. Verfahren nach einem der vorhergehenden Ansprüche, bei dem die Metallpulver irgendeines der Elemente, die in der Tabelle des Periodensystems der Elemente als Übergangsmetalle eingeordnet sind und Atomnummern von 21 bis 30, 39 bis 48, 57 bis 80 und 89 bis 107, jeweils einschließlich, aufweisen, entweder im reinen Zustand oder in Legierung, in verschiedenen Verhältnissen, mit einem oder mehreren der Elemente anderer Gruppen des Periodensystems der Elemente mit den Atomnummern 3, 4, 11, 12, 13, 14, 15, 16, 19, 20, 31 bis 34, 37, 38, 49 bis 52, 55, 56, 81 bis 88 und 58 bis 71 (Lanthanide) und 90 bis 103 (Actinide), jeweils einschließlich, umfassen.

11. Verfahren nach einem der vorhergehenden Ansprüche, bei dem der Grad, bis zu dem die Oxidmatrizen Eigenschaften vom n- und p-Typ aufweisen, durch Einstellen der Oxidationsmenge auf den Oberflächen der Metallteilchen der Pulver entweder durch Einstellen der Verfahrensparameter oder durch Verändern der Position einer hitzebeständigen Röhre in Bezug auf die Hitzequelle und die Strömung der geschmolzenen Teilchen oder durch Auswählen des Größenbereichs der verwendeten Teilchen innerhalb des Bereichs von 1 bis 45 Mikrometern geregelt wird.

12. Verfahren nach einem der vorhergehenden Ansprüche, bei dem die Fähigkeit der Übergangsmetallpulver, die Elemente mit Atomnummern von 21 bis 30, 39 bis 48, 57 bis 80 und 89 bis 107, jeweils einschließlich, enthalten, beim Einfallen von Strahlung Ladungsträger zu bilden, durch Zusatz zu diesen, in verschiedenen Verhältnissen, von einem oder mehreren der Elemente des Periodensystems der Elemente mit den Atomnummern 3, 4, 11, 12, 13, 14, 15, 16, 19, 20, 31 bis 34, 37, 38, 49 bis 52, 55, 56, 81 bis 88 und 58 bis 71 und 90 bis 103, jeweils einschließlich, verbessert wird.

13. Verfahren nach einem der vorhergehenden Ansprüche, bei dem die Dicke der gesprühten Oxidmatrizen, gleichgültig ob vom n- oder p-Typ, und ihre Leitfähigkeit durch Verändern des Oxidationsgrad an der Oberfläche der geschmolzenen Metallteilchen und der Zahl und Geschwindigkeit der Überleitungsvorgänge über das tragende Substrat eingestellt werden.

14. Verfahren nach einem der vorhergehenden Ansprüche, bei dem beim Herstellen der Oxidmatrizen durch Flammenspritzen das Volumenverhältnis von Sauerstoff zu dem entsprechenden Brennstoff in der Verbrennungsflamme doppelt so hoch ist wie das für die stöchiometrische Verbrennung erforderliche.

15. Verfahren nach einem der vorhergehenden Ansprüche, bei dem das Aufbringen eines Laminats aus zwei Oxidmatrizen, wovon eine vom n- und die andere vom p-Typ ist, auf ein geeignet vorbereitetes tragendes Substrat und das darauffolgende Aufbringen einer geeigneten Sammelfläche auf das Oxidlaminat zur Bildung einer Sperrschichtphotodiode führt, die in der Lage ist, beim Einfallen von Kernstrahlung direkt elektrische Energie zu erzeugen.

16. Verfahren nach einem der vorhergehenden Ansprüche, bei dem das Laminat aus zwei Oxidmatrizen vom n- und p-Typ und eine geeignete Sammelfläche auf beiden Oberflächen eines geeignet vorbereiteten tragenden Substrats von Röhren-, Kugel- oder flacher Form oder einer Kombination dieser Formen aufgetragen werden zur Bildung von Sperrschichtphotodiodenkombinationen, die elektrische Energie direkt aus auf die entsprechende Oberfläche aus einer Reihe verschiedener radioaktiver Quellen einfallender Kernstrahlung erzeugen.

## Revendications

1. Procédé de construction d'une diode photovoltaïque capable de générer de l'énergie électrique à partir d'une exposition à un rayonnement nucléaire, le procédé comprenant les étapes consistant à:
(a) préparer des poudres métalliques sèches de métaux transitoires, possédant des particules de configuration asymétrique et dont les granulométries se situent dans le domaine de 1 à 45 micromètres;
(b) préparer la surface d'un substrat de support de telle sorte que la surface soit essentiellement pure du point de vue chimique et électriquement conductrice;
(c) refroidir la surface du substrat de support à une température qui se situe dans le domaine de -200 à - 20°C; et
(d) chauffer les poudres métalliques sèches à une température à laquelle leurs particules sont partiellement portées à fusion, en oxydant ainsi au moins partiellement le métal, déposer l'oxyde porté à fusion sur ladite surface du substrat de support pour former au moins une couche matricielle d'oxyde possédant des caractéristiques de type **n** ou de type **p**, et déposer une couche électroconductrice sur la couche matricielle d'oxyde.

2. Procédé selon la revendication 1, dans lequel les poudres métalliques possèdent des angles rentrants.

3. Procédé selon l'une quelconque des revendications précédentes, dans lequel la surface du substrat de support est refroidie à une température qui se situe dans le domaine de -200 à -100°C.

4. Procédé selon l'une quelconque des revendications précédentes, dans lequel les poudres métalliques sont partiellement portées à fusion par un plasma, par un arc entre deux fils métalliques, entre un fil et une électrode ou encore par un équipement de pulvérisation à la flamme.

5. Procédé selon l'une quelconque des revendications précédentes, dans lequel au moins une matrice d'oxyde de type **n** et au moins une matrice d'oxyde de type **p** sont déposées sur la surface du substrat de support.

6. Procédé selon la revendication 5, dans lequel les oxydes portés à fusion sont déposés sur le substrat pour former un stratifié de matrices d'oxydes comportant des couches alternées possédant des caractéristiques de type **n** et de type **p**.

7. Procédé selon l'une quelconque des revendications précédentes, dans lequel les oxydes portés à fusion sont déposés sur la surface du substrat de support par plusieurs passages par-dessus le substrat.

8. Procédé selon l'une quelconque des revendications précédentes, dans lequel la couche électroconductrice est déposée sur le stratifié d'oxydes par électrodéposition, à l'aide d'un fluide ou sous vide ou encore via un moyen mécanique.

9. Procédé selon l'une quelconque des revendications précédentes, dans lequel on forme les poudres métalliques sèches en faisant exploser dans de l'eau un mélange du métal porté à fusion et en broyant et en séchant ultérieurement les poudres résultantes obtenues par atomisation aqueuse.

10. Procédé selon l'une quelconque des revendications précédentes, dans lequel les poudres métalliques comprennent un quelconque des éléments classés comme métaux transitoires dans le tableau périodique des éléments dont les numéros atomiques se situent dans les domaines de 21 à 30, de 39 à 48, de 57 à 80 et de 89 à 107 inclus, soit à l'état pur, soit à l'état allié dans des proportions variables avec un ou plusieurs des éléments d'autres groupes du tableau périodique des éléments possédant les numéros atomiques 3, 4, 11, 12, 13, 14, 15, 16, 19, 20, 31 à 34 inclus, 37, 38, 49 à 52 inclus, 55, 56, 81 à 88 inclus, et 58 à 71 (lanthanides) et 90 à 103 (actinides) inclus.

11. Procédé selon l'une quelconque des revendications précédentes, dans lequel le degré auquel les matrices d'oxydes manifestent leurs propriétés de type **n** et de type **p** est obtenu en réglant l'amplitude d'oxydation sur les surfaces des particules métalliques des poudres, soit en réglant les paramètres opératoires, soit en faisant varier l'emplacement d'un tube résistant à la chaleur par rapport à la source de chaleur et au courant de particules portées à fusion, soit en sélectionnant la granulométrie des particules utilisées pour qu'elle se situe dans le domaine de 1 à 45 micromètres.

12. Procédé selon l'une quelconque des revendications précédentes, dans lequel on augmente l'aptitude à générer des porteurs de charges à partir de l'incidence du rayonnement manifestée par les poudres métalliques transitoires comprenant des éléments dont les numéros atomiques se situent dans les domaines de 21 à 30 inclus, de 39 à 48 inclus, de 57 à 80 inclus et de 89 à 107 inclus, en leur ajoutant, dans des proportions variables, un ou plusieurs éléments du tableau périodique des éléments possédant les numéros atomiques 3, 4, 11, 12, 13, 14, 15, 16, 19, 20, 31 à 34 inclus, 37, 38, 49 à 52 inclus, 55, 56, 81 à 88 inclus, 58 à 71 inclus et 90 à 103 inclus.

13. Procédé selon l'une quelconque des revendications précédentes, dans lequel on règle l'épaisseur des matrices d'oxydes pulvérisées, qu'elles soient de type **n** ou de type **p**, ainsi que leurs conductivités en faisant varier le degré d'oxydation de la surface des particules métalliques portées à fusion, ainsi que le nombre et la vitesse des passages par-dessus le substrat de support.

14. Procédé selon l'une quelconque des revendications précédentes, dans lequel, lorsqu'on prépare les matrices d'oxydes par pulvérisation à la flamme, le rapport volumique de l'oxygène au combustible associé dans la flamme de combustion représente le double du rapport requis pour une combustion stoechiométrique.

15. Procédé selon l'une quelconque des revendications précédentes, dans lequel la déposition d'un stratifié de deux matrices d'oxydes, une étant de type **n** et l'autre étant de type **p**, sur un substrat de support préparé de manière appropriée et la déposition ultérieure sur le stratifié d'oxyde d'une surface collectrice appropriée fourniront une diode photovoltaïque capable de générer de l'énergie électrique directement à partir de l'incidence du rayonnement nucléaire.

16. Procédé selon l'une quelconque des revendications précédentes, dans lequel on applique le stratifié de deux matrices d'oxydes, de type **n** et de type **p**, et d'une surface collectrice appropriée sur les deux surfaces d'un substrat de support préparé de manière appropriée, qu'il soit de forme plate, tubulaire ou sphérique, ou encore qu'il possède n'importe quelles combinaisons de ces formes, pour obtenir des combinaisons de diodes photovoltaïques qui vont directement générer de l'énergie électrique à partir du rayonnement nucléaire incident sur la surface en question à partir de diverses sources radioactives.
